Europäisches Patentamt

European Patent Office

Office européen des brevets

(11) Numéro de publication: **0 336 337**
A1

## (12) DEMANDE DE BREVET EUROPEEN

(21) Numéro de dépôt: 89105811.7

(51) Int. Cl.⁴: **H01F 7/22**

(22) Date de dépôt: 03.04.89

(30) Priorité: 07.04.88 FR 8804603

(43) Date de publication de la demande:
11.10.89 Bulletin 89/41

(84) Etats contractants désignés:
AT BE CH DE ES FR GB GR IT LI LU NL SE

(71) Demandeur: ALSTHOM
38, avenue Kléber
F-75784 Paris Cédex 16(FR)

(72) Inventeur: Collet, Michel
25, Rue de France
F-69100 Villeurbanne(FR)
Inventeur: Pham, Van Doan
8, Impasse Magendie
F-69330 Meyzieu(FR)
Inventeur: Février, Alain
25, Avenue du Parisis
F-78310 Maurepas(FR)

(74) Mandataire: Weinmiller, Jürgen et al
Lennéstrasse 9 Postfach 24
D-8133 Feldafing(DE)

(54) Limiteur de courant.

(57) L'invention a pour objet un limiteur de courant.

Elle a pour objet un limiteur de courant comprenant un cryostat muni d'une première traversée isolante pour un conducteur d'entrée et une seconde traversée isolante pour un conducteur de sortie, et un conducteur s'étendant d'une traversée à l'autre à l'intérieur de la cuve, ledit conducteur ayant au moins une partie en matériau supraconducteur, le cryostat étant rempli d'un fluide à une température suffisamment basse pour maintenir ledit matériau dans l'état supraconducteur, ladite partie en matériau supraconducteur comportant au moins une paire de fils supraconducteurs (7, 8) enroulés en bobine en sens inverse sur deux mandrins isolants coaxiaux (14, 15), caractérisé en ce que les extrémités de chacun des fils supraconducteurs (7, 8) sont reliées respectivement d'une part au conducteur d'entrée et d'autre part au conducteur de sortie par des amenées élémentaires de courant, identiques (21, 22).

FIG.1

## Limiteur de courant

La présente invention est relative à un limiteur de courant supraconducteur. Un tel limiteur de courant est destiné à être utilisé en série avec un disjoncteur et permet, par la limitation de la valeur du courant qu'il apporte, de réduire fortement l'amplitude du courant de défaut et par conséquent des efforts électrodynamiques sur l'appareillage et de l'énergie de l'arc à couper dans les disjoncteurs.

Un tel limiteur comprend classiquement un élément en matériau susceptible de prendre l'état supraconducteur, par exemple, mais non limitativement du niobium-titane placé dans de l'hélium liquide.

En cas d'élévation de l'intensité du courant, (court-circuit par exemple), celle-ci dépasse l'intensité critique et l'élément retrouve une valeur de résistance importante qui limite la valeur du courant. L'élément supraconducteur est généralement réalisé sous forme d'un fil bobiné de dimensions et de longueurs suffisantes pour tenir la tension rétablie pendant un certain temps jusqu'à l'ouverture d'un disjoncteur en série.

Une difficulté est de réaliser une bobine ayant une auto-inductance suffisamment faible pour éviter les pertes réactives en fonctionnement normal. La bobine de l'art antérieur est habituellement constituée de deux ou quatre bobines en série, enroulées coaxialement en sens inverse l'une par rapport à l'autre. Cette solution ne s'adapte pas facilement aux réseaux à haute tension à cause du problème d'isolement entre l'entrée et la sortie de la bobine.

Dans le cas des enroulements en parallèle, concentriques et bobinés en sens inverse, on résout le problème de l'isolement entre entrée et sortie ; mais avec des fils supraconducteurs cette solution peut conduire à des courants de boucle élevés, à cause de leur résistance électrique pratiquement nulle.

En effet, même avec deux enroulements parfaitements réalisés, pour minimiser l'auto-inductance, une faible perturbation interne ou externe peut provoquer une transition intempestive du supra conducteur.

L'invention propose une solution simple, de mise en oeuvre commode et d'efficacité certaine.

L'invention a pour objet un limiteur de courant comprenant un cryostat muni d'une première traversée isolante pour un conducteur d'entrée et une seconde traversée isolante pour un conducteur de sortie, et un conducteur s'étendant d'une traversée à l'autre à l'intérieur de la cuve, ledit conducteur ayant au moins une partie en matériau supraconducteur, le cryostat étant rempli d'un fluide à une température suffisamment basse pour maintenir ledit matériau dans l'état supraconducteur, ladite partie en matériau supraconducteur comportant au moins une paire de fils supraconducteurs enroulés en bobine en sens inverse sur deux mandrins isolants coaxiaux, caractérisé en ce que les extrémités de chacun des fils supraconducteurs sont reliées respectivement, d'une part au conducteur d'entrée et d'autre part au conducteur de sortie par des amenées élémentaires de courant, identiques.

Dans un mode particulier de réalisation, les amenées élémentaires de courant sont constituées à partir d'un tube ou d'un cylindre conducteur muni de fentes.

L'invention sera bien comprise par la description ci-après d'un mode préféré de réalisation de l'invention, en référence au dessin annexé dans lequel :
  - la figure 1 est une vue en élévation en coupe d'un limiteur selon l'invention,
  - la figure 2 est une section du conducteur selon la ligne II-II de la figure 1,
  - la figure 3 est une vue partielle d'un limiteur de courant selon une variante de réalisation de l'invention.
  - la figure 4 est une section du conducteur . selon la ligne II-II d'une variante d'amenée de courant,

Le limiteur comprend un cryostat métallique 1 constitué de deux parois 50 et 51 séparées par un espace 52 maintenu sous vide. Le cryostat est partiellement rempli de fluide 2 à une température permettant au bobinage utilisé de prendre l'état supraconducteur.

Dans le cas où le bobinage est réalisé en fil de niobium-titane, le fluide utilisé est de l'hélium liquide.

La cuve est surmontée de deux traversées isolantes 3 et 4 à travers lesquelles passe des conducteurs 5A et 5B respectivement munis chacun d'une gaine isolante 10A, 10B.

A la partie supérieure des traversées, où règne une température proche de l'ambiante, le conducteur 5A, 5B est en cuivre-massif.

On ne décrira maintenant que le côté arrivée du courant (côté gauche de la figure) puisque le côté de départ est identique. Les parties arrivées sont indiquées avec l'index A et les parties départ avec l'index B.

Au dessous d'un point P, situé au-dessus de la cuve, le conducteur 5A est fendu en deux (ou plusieurs) parties égales sur toute sa longueur, jusqu'à un point Q dans la partie liquide du fluide.

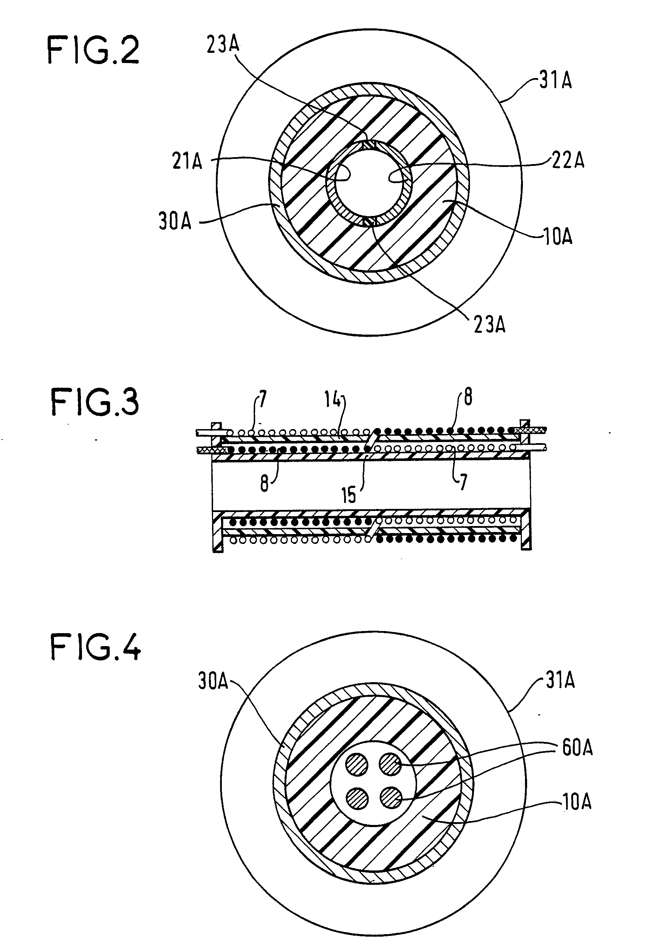

La figure 2 montre ainsi le conducteur 5A, qui est un tube, séparé en deux parties 21A et 22A, appelées amenées élémentaires de courant et isolées électriquement l'une de l'autre par des fentes 23A remplies par un isolant solide de même nature ou non de celle de la gaine 10A.

Les fils supraconducteurs 7 et 8 de la bobine sont reliés respectivement aux extrémités des amenées de courant élémentaires 22A et 21A au point Q.

La gaine isolantes 10A, s'étend depuis le haut des traversées jusque sous le niveau R de l'hélium liquide.

Pour le protéger de la faible tenue diélectrique ambiante, il sera avantageux de munir extérieurement la gaine 10A d'une couche conductrice 30A reliée au potentiel de la cuve.

L'extrémité de cette couche 30A est reliée électriquement à un anneau de garde 31A, situé dans la partie liquide.

L'extrémité de la gaine isolante 10A est située à une distance suffisante sous l'anneau de garde 31A pour assurer la tenue diélectrique dans l'hélium liquide.

Au-delà des jonctions en Q, les deux fils supraconducteur 7, 8, après une portion commune, sont enroulés sur deux manchons isolants coaxiaux respectivement 14 et 15, maintenus par des supports isolants 16 et 17 fixés à la cuve.

L'hélium circule librement à l'intérieur des manchons.

Le bobinage des deux fils 7 et 8 sur leur manchon respectif est effectué en sens inverse pour annuler la valeur de l'auto-inductance de l'ensemble.

Grace à la disposition qui vient d'être décrite, le courant de boucle entre deux enroulements en parallèle ne voit pas une résistance électrique nulle due à la supraconductivité, mais une résistance correspondant environ à quatre fois la résistance, d'une amenée de courant élémentaire telle que 21A.

Pour rendre encore plus faible l'inductance de la bobine, il est avantageux de réaliser une transposition des fils supraconducteurs 7 et 8 au milieu des bobinages, comme le montre la figure 3.

Selon l'invention, dans le cas où l'on veut augmenter le courant nominal traversant le limiteur supraconducteur, il suffit d'augmenter le nombre d'amenées élémentaires de courant et d'enroulements supraconducteurs en parallèle dans la même proportion.

Ainsi à chaque extrémité de chaque fil supraconducteur correspondant une amenée élémentaire de courant.

Le conducteur 5 peut avoir 2, 4 ou 6, voir plus, amenées élémentaires de courant en fonction du courant nominal demandé.

On règle la résistance électrique d'une amenée élémentaire de courant en faisant varier sa longueur, sa section et sa résistivité (cuivre, alliage d'aluminium...). La valeur de la résistance électrique d'une amenée élémentaire de courant peut dépasser plusieurs centaines de micro-ohms.

La figure 4 montre une variante d'amenée de courant. Elle est constituée de tiges conductrices parallèles identiques 60A disposées symétriquement sur une circonférence à l'intérieur de la gaine isolante 10A remplie partiellement de fluide réfrigérant.

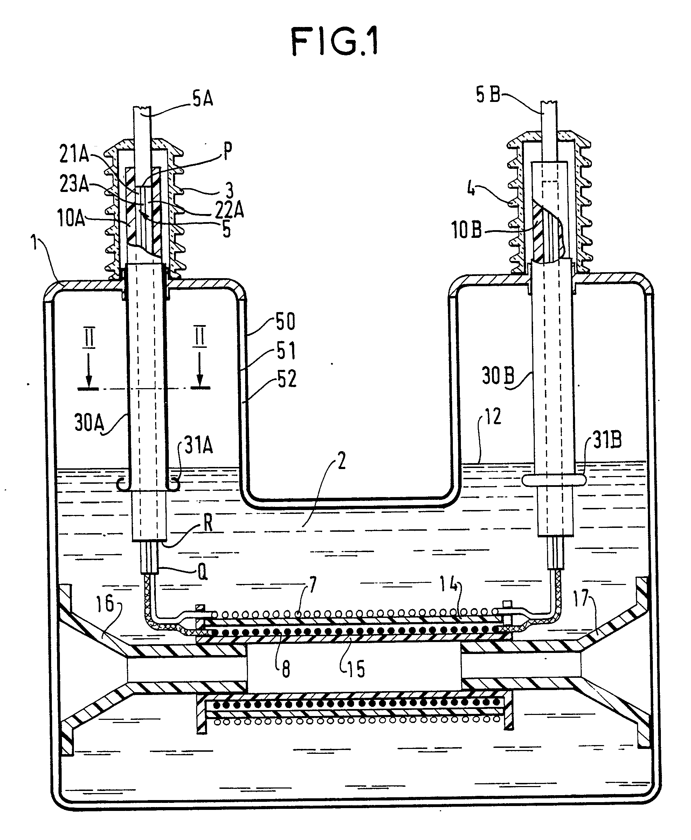

Une extrémité des tiges 60A est reliée à une plaque conductrice commune (non représentée), située au niveau P (figure 1), l'autre extrémité est reliée à un fil supraconducteur.

Les amenées élémentaires de courant sont maintenues rigidement à l'aide des disques isolants munis de trous pour le passage du fluide réfrigérant et montés à l'intérieur de la gaine 10.

Un de ces disques est fixé au niveau R.

En variante, non représentée, les amenées élémentaires de courant sont constituées par des tubes conducteurs coaxiaux séparés par un isolant, dont une extrémité est fixée à une plaque commune et l'autre à un fil supraconducteur.

## Revendications

1/ Limiteur de courant comprenant un cryostat muni d'une première traversée isolante pour un conducteur d'entrée et une seconde traversée isolante pour un conducteur de sortie, et un conducteur s'étendant d'une traversée à l'autre à l'intérieur de la cuve, ledit conducteur ayant au moins une partie en matériau supraconducteur, le cryostat étant rempli d'un fluide à une température suffisamment basse pour maintenir ledit matériau dans l'état supraconducteur, ladite partie en matériau supraconducteur comportant au moins une paire de fils supraconducteurs (7, 8) enroulées en bobine en sens inverse sur deux mandrins isolants coaxiaux (14, 15), caractérisé en ce que les extrémités de chacun des fils supraconducteurs (7, 8) sont reliées respectivement d'une part au conducteur d'entrée et d'autre part au conducteur de sortie par des amenées élémentaires de courant, identiques (21A, 22A).

2/ Limiteur de courant selon la revendication 1, caractérisé en ce que les amenées élémentaires de courant (21A, 22A) sont constituées à partir d'un tube ou d'un cylindre conducteur muni de fentes (23A).

3/ Limiteur de courant selon la revendication 2, caractérisé en ce que les fentes (23A) sont d'épaisseur très faible et remplies d'isolant.

4/ Limiteur de courant selon la revendication 1, caractérisé en ce que les amenées élémentaires de courant sont constituées de tiges conductrices (60A) identiques parallèles disposées symétriquement sur une circonférence à l'intérieur d'une gaine isolante (10A) remplie en partie de fluide réfrigérant, une extrémité des tiges étant reliée à une plaque conductrice commune, l'autre extrémité étant reliée à un fil supraconducteur.

5/ Limiteur de courant selon la revendication 1, caractérisé en ce que les amenés élémentaires de courant sont constituées par des tubes conducteurs concentriques de résistance électrique similaire séparés par un espace isolant, une extrémité de chaque tube étant reliée à un fil supraconducteur, l'autre extrémité étant reliée à une plaque conductrice commune.

6/ Limiteur de courant selon l'une des revendications 1 à 5 caractérisé en ce que les fils supraconducteurs (7, 8) sont transposés au milieu des bobines.

# FIG.1

FIG.2

FIG.3

FIG.4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4 ) |
|---|---|---|---|
| X | US-A-3412320 (VARIAN ASSOCIATES) <br> * colonne 2, ligne 70 - colonne 3, ligne 70 * <br> --- | 1-3 | H01F7/22 |
| A | FR-A-2178438 (COMPAGNIE GENERALE D'ELECTRICITE) <br> * page 2, ligne 16 - page 3, ligne 9 * <br> --- | 1, 4 | |
| A | FR-A-1425548 (S.A. D'ETUDES ET REALISATIONS NUCLEAIRES SODERN) <br> * page 1, colonne de droite, ligne 30 - page 2, colonne de droite, ligne 34 * <br> --- | 1, 4 | |
| A | DE-A-1765247 (SIEMENS AKTIENGESELLSCHAFT) <br> * page 4, ligne 1 - ligne 19 * <br> --- | 1, 5 | |
| A | US-A-4658229 (GA TECHNOLOGIES INC.) <br> * colonne 6, ligne 47 - colonne 8, ligne 20 * <br> --- | 6 | |
| A | FR-A-2135857 (CIT-ALCATEL) <br> --- | | |
| A | FR-A-1416691 (WESTINGHOUSE ELECTRIC CORPORATION) <br> --- | | DOMAINES TECHNIQUES RECHERCHES (Int. Cl.4 ) |
| A | US-A-3252018 (MALAKER LABORATORIES) <br> --- | | |
| A | US-A-3185900 (BELL TELEPHONE LABORATORIES) <br> ----- | | H01F <br> H02H |

Le présent rapport a été établi pour toutes les revendications

| Lieu de la recherche | Date d'achèvement de la recherche | Examinateur |
|---|---|---|
| LA HAYE | 23 JUIN 1989 | VANHULLE R. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

             

& : membre de la même famille, document correspondant

EPO FORM 1503 03.82 (P0402)